(19) Europäisches Patentamt / European Patent Office / Office européen des brevets

(11) **EP 1 909 397 A1**

(12) **EUROPEAN PATENT APPLICATION**

(43) Date of publication:
**09.04.2008 Bulletin 2008/15**

(51) Int Cl.:
*H04B 1/06* [(2006.01)]    *H04L 27/06* [(2006.01)]
*H04L 27/14* [(2006.01)]    *H03D 1/02* [(2006.01)]
*H03D 3/00* [(2006.01)]

(21) Application number: 06425684.5

(22) Date of filing: **06.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **STMicroelectronics S.r.l.**
**20041 Agrate Brianza (Milano) (IT)**

(72) Inventor: **Adduci, Francesco,**
**c/o STMicroelectronics S.r.l.**
**20041 Agrate Brianza (MI) (IT)**

(74) Representative: **Perani, Aurelio et al**
**Perani Mezzanotte & Partners**
**Piazza San Babila, 5**
**20122 Milano (IT)**

(54) **Demodulation of AM and FM using the Teager-Kaiser operator**

(57)     A receiver (1) for receiving an analog radio frequency signal (x(t)) comprises analog-digital converter means (20,21) able to receive the analog signal (x(t)) in input for converting the analog signal (x(t)) into a digital signal (x(n)) and processing means (30,31) able to apply a non-linear Teager-Kaiser function ($\Psi$) to the digital signal x(n) for generating a first signal ($\Psi[x(n)]$) representative of the energy content of the digital signal (x(n)), process the digital signal (x(n)) for generating a derivative signal (x'(n)) representative of the derivative of the digital signal (x(n)), apply said non-linear Teager-Kaiser function ($\Psi$) to the derivative signal (x'(n)) for generating a second signal ($\Psi[x'(n)]$) representative of the energy content of the derivative (x'(n)) and process the first signal ($\Psi[x(n)]$) and the second signal ($\Psi[x'(n)]$) for generating at least one characteristic information of the digital signal (x(n)).

FIG.1

**Description**

The present invention refers to a receiver for an analog radio frequency signal in accordance-with the preamble of claim 1.

Receivers for analog radio frequency signals are known in the state of the art and are used for recovering the data contained in the analog signal.

In particular, receivers for analog radio frequency or RF signals are used for receiving AM amplitude modulated signals and FM frequency modulated signals.

In accordance with the prior art, a receiver for AM-FM signals comprises a tuneable filter coupled to an antenna for filtering the analog signal drawn from the antenna, a voltage controlled oscillator or VCO and one or more mixers able to convert the frequency of the selected carrier into an intermediate frequency.

The receiver also comprises filtering stages, achieved for example with ceramic filters, amplification stages with circuits for the automatic gain control, a phase-locked loop or PLL for the selection and centring of the tuning frequency of the filters, a reference oscillator and various interfaces.

The receiver moreover comprises a circuitry for the signal in baseband and limiters to limit the dynamics of the FM signal and to permit the receiver to work with an FM signal at constant module. Receivers of the abovementioned type finally comprise the blocks necessary to achieve stereo decoding, demodulation, control of the quality parameters and final amplification.

A receiver of the abovementioned type requires numerous circuitry components and complex processing algorithms for demodulating the received modulated signal. Moreover, the conversion of the received signal from the frequency of the selected carrier to an intermediate frequency requires the use of mixers, whose cost is found to substantially affect the overall cost of the receiver, as does the cost of the external filters for the intermediate frequency.

Furthermore, it should be pointed out that in the presence of modulated signals with low signal-noise ratio, the complexity of the logic circuits increases so to obtain a demodulated signal which is satisfactory from the standpoint of the signal-noise ratio.

In view of the described state of the art, object of the present invention is that of making a receiver with a simple structure and with a reduced number of components capable at the same time of reducing the overall cost of the receiver.

Such object is achieved by a receiver in accordance with claim 1.

Due to the use of the receiver according to the invention, the required circuitry for receiving and demodulating the received modulated signal is drastically reduced. In particular, the receiver according to the invention does not require the use of costly devices such as the mixers and external filters for the intermediate frequency.

Further characteristics and advantages of the receiver according to the present invention will be clear from the following description of a preferred embodiment, given as indicative and non-limiting, with reference to the attached figures, wherein:

- Figure 1 represents the block diagram of a receiver in accordance with the present invention, and
- Figure 2 represents the block diagram of a detail of the receiver of figure 1.

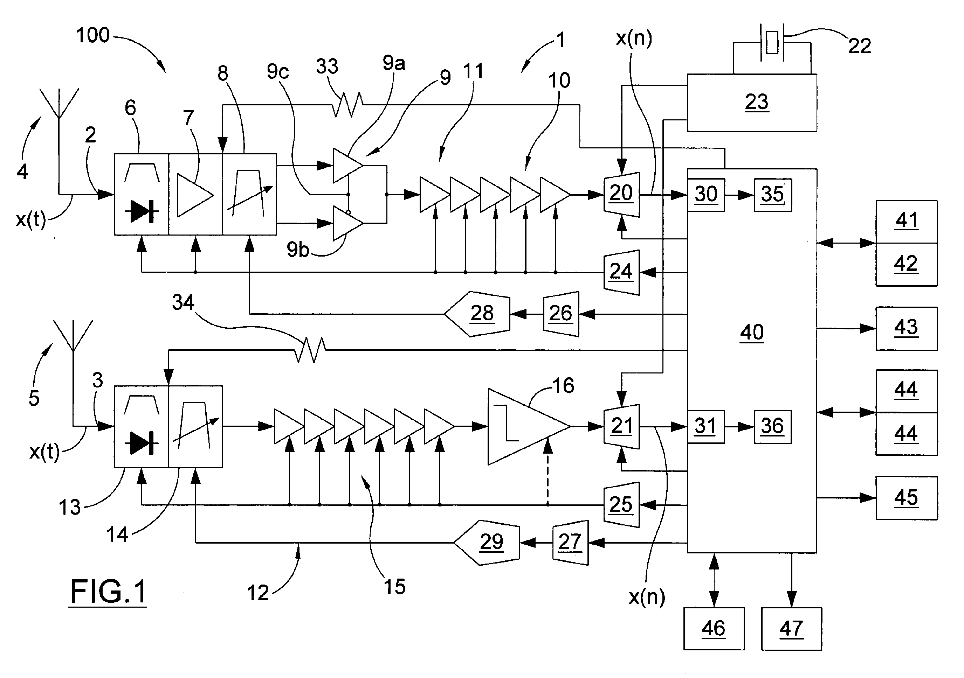

With reference to figure 1, with 1 a receiver is indicated in its entirety, able to receive an analog radio frequency signal x(t).

In particular, the analog signal x(t) is a modulated analog signal, of AM or FM type, generically expressed by the formula:

$$x(t) = a(t) \cdot \cos(\Omega_c t + \Omega_m \int_0^t q(\tau)d\tau + \phi) \qquad (1)$$

where a(t) represents the AM modulating signal component and q(t) the FM modulating signal component.

The receiver 1 has at least one signal input able to receive the modulated analog signal x(t).

In the example, the receiver 1 has two inputs 2,3 coupled to a respective reception antenna 4,5. In particular, the signal input 2 is intended to receive an AM modulated signal from the antenna 4 for AM signals and the signal input 3 is intended to receive an FM modulated signal from the antenna 5 for FM signals. Alternatively, a single reception antenna can be provided for AM and FM signals, coupled to the signal inputs 2 and 3. Alternatively, the receiver 1 can be coupled to an electronic device, such as a cellular phone, a PDA, a computer, etc., intended to provide the modulated analog signal x(t).

Advantageously, the analog signal x(t) drawn from the antennas 4 and 5 is filtered and amplified by means of filtering and amplifying means. Since the receiver 1 is intended to receive both AM and FM signals, the receiver 1 comprises a circuitry, indicated with 11 in its entirety, for filtering and amplifying an AM signal and a circuitry, indicated overall with 12, for filtering and amplifying an FM signal.

The circuitry 11 intended to filter and amplify an AM signal comprises a first band-pass filter 6 input coupled to the signal input 2 for filtering the signal x(t) drawn from the antenna 4, a low-noise amplifier 7 input coupled to the output of the band-pass filter 6 to amplify the signal output from the band-pass filter 6 and a second band-pass filter 8 input coupled to the output of the low-noise amplifier 7 to filter the signal output from the amplifier 7. In particular, the first band-pass filter 6 is a broadband filter of selection of the AM signal band and is intended to filter the noise outside the band, while the band-pass filter 8 is a narrow band filter, has a controllable central tuning frequency $f_c$, and is able to select a specific channel. The second band-pass filter 8 has two outputs connected to the input of two band-pass amplifiers 9a,9b of an amplification stage 9. The two amplifiers 9a,9b are able to amplify the respective signals output from the band-pass filter 8 and have two distinct bands corresponding to the band of the medium wave AM signals and to the band of the long wave AM signals, also called LW signals. The two amplifiers 9a,9b can be alternately activated by means of a control signal on the terminal 9c, which assumes 0 or 1 value depending on whether the receiver 1 is set on the AM signal band or on the LW signal band. The amplification stage 9 is coupled in output to a plurality of amplifiers, indicated in their entirety with 10, connected in series with each other and able to amplify the signal output from the amplification stage 9, so to provide a filtered and amplified signal.

The circuitry 12 intended to filter and amplify an FM signal comprises a first band-pass filter 13 input coupled to the input of signal 3 for filtering the signal x(t) drawn from the antenna 5, a second band-pass filter 14 input coupled to the output of the first band-pass filter 13 for filtering the signal output from the first filter 13. In particular, the first band-pass filter 13 is a broadband filter of selection of the FM signal band and is intended to filter the outside-band noise, while the band-pass filter 14 is a narrow band filter, has a controllable central tuning frequency $f_c$ and is able to select a specific channel. The receiver 1 moreover comprises a plurality of amplifiers, indicated with 15 in their entirety, cascade connected and able to amplify the signal output from the band-pass filter 14, and a limiter amplifier or limiter 16 able to amplify the signal output from the chain of amplifiers 15 and to keep constant the module of the signal output from the amplifier itself.

In accordance with a preferred embodiment, one or more amplifiers of the amplifier means have two threshold values, advantageously adjustable, for the automatic control of the amplifier gain. Specifically, the two threshold values are a first threshold value NAGC which establishes the maximum level of the in-band input signal and the maximum amplification level on the output signal and a second threshold value WAGC which establishes the maximum level of the outside-band input signal.

The analog signal x(t), filtered and amplified through the filters and the amplifiers of the circuitries 11 and 12, is converted into a digital signal x(n) by means of analog-digital converter means, respectively 20 and 21, controllable by respective sampling signals having a sampling frequency $f_s$.

In order to control the converter means 20,21, the receiver 1 comprises an oscillator 22 which provides the timing signal to a phase linking loop or PLL 23, advantageously with low jitter, which generates the timing signals for the frequency tuning of the band-pass filters 8 and 14 and for the sampling frequency $f_s$ of the analog-digital converter means 20,21.

The digital signal x(n) output from the converter means 20 and 21 can be generically expressed with the following formula:

$$x(n) = a(n) \cdot \cos\left(\Omega_c \cdot n + \Omega_m \cdot \int_0^n q(v) \cdot dv + \phi\right) \qquad (2)$$

where

a(n) represents the AM modulating signal component with time-varying envelope $|a(n)|$,
$\vartheta(n) = \Omega_c + \Omega_m \cdot q(n)$ represents the instantaneous angular frequency,
q(n) the FM modulating signal component where

$$|q(n)| \leq 1 \ \forall n \in \{I \geq 0\} \ \ 0 \leq \Omega_c \pm \Omega_m \leq \pi$$

In accordance with a preferred embodiment, the analog-digital converters 20 and 21 convert the analog signal x(t) into a 20 bit digital signal x(n). Nevertheless, as needed, it is possible to foresee an analog-digital conversion with a different number of bits.

The receiver 1 according to the invention moreover comprises processing means, indicated in their entirety with 30 and 31, able to receive in input the digital signal x(n) generated by the converted means 20 and 21. In particular, the analog-digital converter 20 is coupled to the processing means 30 while the analog-digital converter 21 is coupled to the processing means 31.

The processing means 30 and 31 are able to apply a non-linear Teager-Kaiser function $\Psi$ to the digital signal x(n) for generating a first signal $\Psi[(x(n)]$ representative of the energy content of the digital signal x(n) where

$$\Psi\big[x(n)\big] = \big[x(n)\big]^2 - x(n+1) \cdot x(n-1) \qquad (3)$$

In the specific case, in which

$$\Psi\big[x(n)\big] \approx a^2(n) \cdot \sin^2\big[\Omega_c + \Omega_m \cdot q(n)\big] \qquad (4).$$

The non-linear Teager-Kaiser $\Psi$ operator is for example described in the document "On a Simple Algorithm to Calculate the Energy of a Signal" by James F. Kaiser, PROC. ICASSP, Vol. S7.3, pps. 381-384, 1990, incorporated here for reference. The non-linear Teager-Kaiser $\Psi$ operator determines the "energy" of a signal, or rather its energy content. In other words, this algorithm produces as result a value which was shown to be directly correlated to the "energy" of the signal being analysed. Below, the definition of non-linear Teager-Kaiser operator will be illustrated so to clarify the following description of the invention. The non-linear Teager-Kaiser is defined by the following relation:

$$\Psi_c\big[x(n \cdot T)\big] = \left(\frac{\partial}{\partial(n \cdot T)} x(n \cdot T)\right)^2 - x(n \cdot T) \cdot \left(\frac{\partial^2}{\partial(n \cdot T)^2} x(n \cdot T)\right)$$

$$\Psi_c\big[x(n \cdot T)\big] = \left(\frac{\partial}{\partial(n \cdot T)} x(n \cdot T)\right)^2 - x(n \cdot T) \cdot \left(\frac{\partial^2}{\partial(n \cdot T)^2} x(n \cdot T)\right) \quad (1)$$

Using the general property of the derivatives in the discrete domain and maintaining the coherence between the samples with the primitive function and its derivatives, it is possible to obtain, removing the notion of the time T, that:

$$\overset{\circ}{x}(n) = \frac{x(n+1) - x(n-1)}{2}$$

or

$$\overset{\circ}{x}(n) = x(n+1) - x(n)$$

and

$$\overset{\circ\circ}{x}(n) = x(n+1) + x(n-1) - 2 \cdot x(n)$$

so that:

$$\Psi\big[x(n)\big] = \big[x(n+1) - x(n)\big]^2 - x(n+1) \cdot \big[x(n+1) + x(n-1) - 2 \cdot x(n)\big]$$

From which the above reported expression (3) is obtained

$$\Psi\big[x(n)\big] = \big[x(n)\big]^2 - x(n+1) \cdot x(n-1) \ .$$

The processing means 30,31 can be implemented through hardware circuitry or a sequence of logic instructions or software.

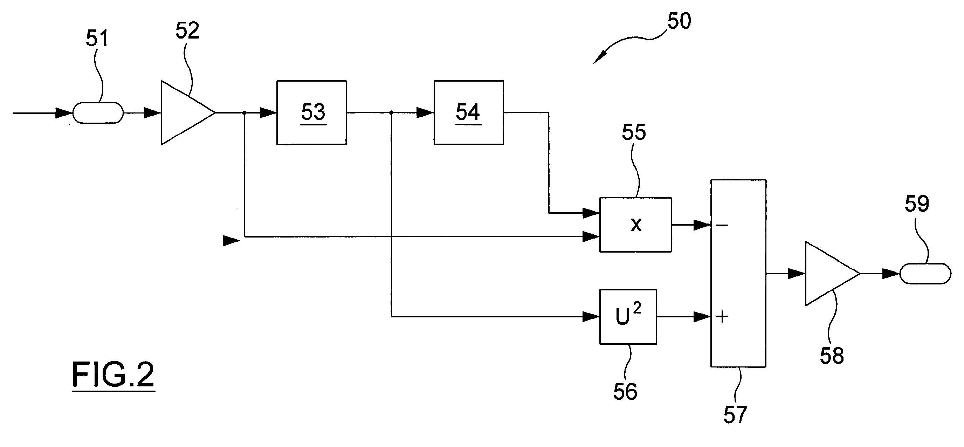

In accordance with one embodiment, the processing means 30,31 comprise a circuit 50 (figure 2), able to apply the non-linear Teager-Kaiser function or operator to the signal x(n) for generating the signal $\Psi[x(n)]=[x(n)]^2-x(n+1)\cdot x(n-1)$ representative of the energy content of the signal x(n). It should be pointed out that the same circuit 50 can be used for applying the Teager-Kaiser function to any signal entering the circuit 50.

The circuit 50 comprises an input 51 able to receive the signal x(n), preferably but not necessarily a pre-amplification stage 52 for amplifying the signal x(n), a first delay block 53 and a second delay block 54.

The first delay block 53 is connected to the input 51 and is able to delay the input signal x(n) by one sample, while the second delay block 54 is input connected to the output of the first delay block 53 and is able to delay the signal output from the first delay block 53 by one sample.

The circuit 50 moreover comprises a multiplier 55 connected to the input 51 and to the output of the second delay block 54 to multiply the signal x(n) at the input 51 and the signal at the output of the second delay block 54, and a block 56 for squaring the signal output from the first delay block 53.

An adder block 57 is foreseen in the circuit 50 and has a positive input connected to the output of the block 56 and a negative input connected to the output of the multiplier block 55.

Preferably, the circuit 50 comprises a post-amplification stage 58 for amplifying the signal output from the adder block 57.

Finally, the circuit 50 has an output 59 from which the output signal is drawn.

In the case in which the sample x(n-1) of the signal x(n) is present at the input 51 of the circuit 50, the signal at the output 59 is represented by the expression (3) stated above.

$$\big[x(n)\big]^2 - x(n+1) \cdot x(n-1)$$

or rather the Teager Kaiser $\Psi[x(n)]$ function of the signal x(n).

The processing means 30,31 are moreover able to process the digital signal x(n) for generating a derivative signal x'(n) representative of the derivative of the digital signal x(n) and to apply the non-linear Teager-Kaiser function $\Psi$ to the derivative signal x'(n) for generating a second signal $\Psi[x'(n)]$ representative of the energy content of the derivative x'(n) of the digital signal x(n), where

$$x'(n) = x(n) - x(n-1) \qquad\qquad (5)$$

$$\Psi\big[x'(n)\big] = \Psi\big[x(n) - x(n-1)\big] =$$

$$= \Psi\big[x(n)\big] + \Psi\big[x(n-1)\big] - x(n-1) \cdot x(n) + x(n-2) \cdot x(n+1) \qquad\qquad (6)$$

In the specific case, in which $x(n) = a(n) \cdot \cos\left(\Omega_c \cdot n + \Omega_m \cdot \int_0^n q(v) \cdot dv + \phi\right)$, applying the symmetric difference algorithm for which

$$\Psi[x'(n)] = \frac{\Psi[x(n+1) - x(n-1)]}{2},$$

$$\Psi\left[x(n+1) - x(n-1)\right] \approx 4 \cdot a^2(n) \cdot \sin^4\left[\Omega_c + \Omega_m \cdot q(n)\right] \text{ is obtained.} \tag{7}$$

The processing means 30,31 are moreover able to process the first signal $\Psi[x(n)]$ and the second signal $\Psi[x'(n)]$ to obtain the modulating signal. Specifically, the processing means 30 process the first signal $\Psi[x(n)]$ and the second signal $\Psi[x'(n)]$ for generating the modulating signal $a(n)$ of the modulated signal $x(n)$ of AM type, while the processing means 31 process the first signal $\Psi[x(n)]$ and the second signal $\Psi[x'(n)]$ for generating the modulating signal $q(n)$ of the modulated signal $x(n)$ of FM type, where

$$a(n) \cong \frac{2 \cdot \Psi\left[x(n)\right]}{\sqrt{\Psi\left[x(n+1) - x(n-1)\right]}} \tag{8}$$

and

$$q(n) \cong \frac{1}{2 \cdot \Omega_m} \cdot \arccos\left(1 - \frac{\Psi\left[x(n+1) - x(n-1)\right]}{2 \cdot \Psi\left[x(n)\right]}\right) - \frac{\Omega_c}{\Omega_m} \tag{9}$$

It should be said that the signal $\Psi(x'(n))$, which represents the application of the Teager-Kaiser function to the derivative $x'(n)$ of the modulated signal $x(n)$, can be obtained by applying the backward difference algorithm for which $\Psi[x'(n)] = \Psi[x(n)-x(n-1)]$ from which it is obtained that

$$a(n) \cong \sqrt{\frac{\Psi\left[x(n)\right]}{1 - \left(1 - \frac{\Psi\left[x(n) - x(n-1)\right] + \Psi\left[x(n+1) - x(n)\right]}{4 \cdot \Psi\left[x(n)\right]}\right)^2}} \tag{10}$$

and

$$q(n) \cong \frac{1}{\Omega_m} \cdot \arccos\left(1 - \frac{\Psi\left[x(n) - x(n-1)\right] + \Psi\left[x(n+1) - x(n)\right]}{4 \cdot \Psi\left[x(n)\right]}\right) - \frac{\Omega_c}{\Omega_m} \tag{11}.$$

The size FMerr of the error introduced by the application of the symmetrical difference algorithm for a modulated signal $x(n)$ of FM type assumes a minimum value if

$$f_s/f_c = 4/k \qquad \text{with } k > 0$$

which has $f_s = 2f_c$ and $f_s = 4f_c$ solution. Excluding $f_s = 2f_c$ for noise considerations, the minimum sampling frequency $f_s$ must be equal to 4 times the frequency of the carrier $f_c$.

The size FMerr of the error introduced by the application of the retrograde difference algorithm for a modulated signal x(n) of FM type assumes a minimum value if

$$f_s/f_c = 6/k \qquad \text{with } k > 0$$

which has $f_s = 3f_c$ and $f_s = 6f_c$ solution. Excluding $f_s = 6f_c$ for noise considerations, the minimum sampling frequency $f_s$ must be equal to 3 times the frequency of the carrier $f_c$.

The size AMerr of the error introduced by the application of the aforesaid algorithms for a modulated signal x(n) of AM type is proportional to the square of $\Omega_a$ and is therefore negligible for small values of $\Omega_a$.

Advantageously, the receiver 1 comprises filtering means 35,36 able to filter the first signal $\Psi[x(n)]$ and the second signal $\Psi[x'(n)]$ generated by the processing means 30,31 to respectively obtain a first filtered signal $\Psi_F[x(n)]$ and a second filtered signal $\Psi_F[x'(n)] = \Psi_F[x(n+1) - x(n-1)]$, in which:

$$\Psi_F\left[x(n)\right] = A^2 \cdot \left[1 + m \cdot \sin\left(\Omega_a \cdot n\right)\right]^2 \cdot \sin^2\left(\Omega_c + \Omega_m \cdot q(n)\right) \qquad (12)$$

and

$$\Psi_F\left[x(n+1) - x(n-1)\right] = 4 \cdot A^2 \cdot \left[1 + m \cdot \sin\left(\Omega_a \cdot n\right)\right]^2 \cdot \sin^4\left(\Omega_c + \Omega_m \cdot q(n)\right) \quad (13).$$

where the modulated source signal x(n) is represented by

$$x(n) = A \cdot \left[1 + m \cdot \sin\left(\Omega_a \cdot n\right)\right] \cdot \cos\left(\Omega_c \cdot n + \Omega_m \cdot \int_0^n q(v) \cdot dv + \phi\right) \qquad (14).$$

In the case of signal x(n) of AM type, the filtering means 35 filter the first signal $\Psi[x(n)]$ for generating the first filtered signal $\Psi_{F_{AM}}[x(n)]$ and the second signal $\Psi[x'(n)]$ for generating the second filtered signal $\Psi_{F_{AM}}[x(n+1)] - x(n-1)]$ where:

$$\Psi_{F_{AM}}\left[x(n)\right] = A^2 \cdot \left[1 + m \cdot \sin\left(\Omega_a \cdot n\right)\right]^2 \cdot \sin^2 \Omega_c \qquad (15)$$

e

$$\Psi_{F_{AM}}\left[x(n+1) - x(n-1)\right] = 4 \cdot A^2 \cdot \left[1 + m \cdot \sin\left(\Omega_a \cdot n\right)\right]^2 \cdot \sin^4 \Omega_c \qquad (16).$$

In the case in which x(n) is of FM type, the filtering means 36 filter the first signal $\Psi[x(n)]$ for generating the first filtered signal $\Psi_{F_{FM}}[x(n)]$ and the second signal $\Psi[x'(n)]$ for generating the second filtered signal $\Psi_{F_{FM}}[x(n+1) - x(n-1)]$ where:

$$\Psi_{F_{FM}}\left[x(n)\right] = A^2 \cdot \sin^2\left(\Omega_c + \Omega_m \cdot q(n)\right) \qquad (17)$$

and

$$\Psi_{F_{FM}}\left[x(n+1)-x(n-1)\right]=4\cdot A^2\cdot\sin^4\left(\Omega_c+\Omega_m\cdot q(n)\right) \qquad (18).$$

The signal x(n) as represented by the expression (14) is characterised by the following characteristic parameters:

The amplitude A of the AM modulated signal, the index m of AM modulation, the angular frequency $\Omega_a$ of AM modulation, the angular frequency $\Omega_c$ of the carrier signal, the angular frequency deviation $\Omega_m$ or MPX angular frequency, the angular frequency $\Omega q$ of the FM modulating signal.

The carrier frequency $f_c \underset{=}{\triangle} \dfrac{\Omega_c\cdot f_s}{2\cdot\pi}$ is an important parameter for verifying the reception channel centring.

In the case of a FM signal, the processing means 31 are able to process the first filtered signal $\Psi_{F_{FM}}[x(n)]$ and the second filtered signal $\Psi_{F_{FM}}[x(n+1)-x(n-1)]$ for generating the value $f_c$, where

$$f_c=\frac{1}{N}\cdot\frac{f_s}{2\cdot\pi}\cdot\sum_{n=1}^{N}\frac{1}{2}\cdot\arccos\left(1-\frac{\Psi_{F_{FM}}\left[x(n+1)-x(n-1)\right]}{2\cdot\Psi_{F_{FM}}\left[x(n)\right]}\right)= \qquad (19)$$

$$=\frac{1}{N}\cdot\frac{f_s}{2\cdot\pi}\cdot\sum_{n=1}^{N}\left[\Omega_c+\Omega_m\cdot q(n)\right] \qquad (20).$$

In order to calculate the value of the expression (19), the value of the number N of samples to be analysed must be established, a value which varies as a function of the precision $f_{prec}$ with which it is desired to calculate the value of the carrier frequency $f_c$, where

$$f_{prec}\le\frac{2f_m}{\Omega_q N}$$

from which it is obtained that the number of samples N must satisfy the relation:

$$N\le\frac{2f_m}{\Omega_q f_{prec}}$$

in which:

$f_m$ is known and is equal to the frequency deviation of the modulating frequency in an FM transmission, typically equal to 75 KHz,
$\Omega_q$ is known and is equal to the angular bandwidth of the FM modulating signal in an FM transmission, typically equal to 15 KHz,
$f_{prec}$ is set by the user.

If it is desired to determine the exact angular frequency deviation $\Omega_m$ one may proceed by processing the first filtered signal $\Psi_{F_{FM}}[x(n)]$ and the second filtered signal $\Psi_{F_{FM}}[x(n+1)-x(n-1)]$ as stated in the expression (9), such to obtain

$$q(n)\cdot\Omega_m \cong \frac{1}{2}\cdot \arccos\left(1-\frac{\Psi_{F_{FM}}\big[x(n+1)-x(n-1)\big]}{2\cdot\Psi_{F_{FM}}\big[x(n)\big]}\right)-\Omega_c \qquad (21)$$

from which $\Omega_m$ is obtained since, as already stated, $|q(n)|\leq 1 \;\forall_n \in \{l \geq 0\}$.

Advantageously, if it is desired to consider the variations of q(n), the processing means 31 are able to apply the Teager-Kaiser $\Psi$ function to the signal $q(n)\Omega_m$ obtained from (21) so for generating a third signal $\Psi[\Omega_m\cdot q(n)]$, calculate the derivative q'(n) of the signal $q(n)\Omega_m$, apply the Teager-Kaiser $\Psi$ to the derivative q'(n) of the signal $q(n)\Omega_m$ so for generating a fourth signal $\Psi[\Omega_m\cdot q(n+1) - \Omega_m\cdot q(n-1)]$ and process the third signal $\Psi[\Omega_m\cdot q(n)]$ and the fourth signal $\Psi[\Omega_m\cdot q(n+1)-\Omega_m\cdot q(n-1)]$ so for generating the value of $\Omega_m$ by applying the following expression:

$$\Omega_m = \frac{2\cdot\Psi\big[\Omega_m\cdot q(n)\big]}{\sqrt{\Psi\big[\Omega_m\cdot q(n+1)-\Omega_m\cdot q(n-1)\big]}} \qquad (22)$$

Subsequently, it is possible to determine the value $\Omega_q$ of the angular bandwidth of the FM modulating signal. To this end, the processing means 31 are able to process the signal $\Psi[\Omega_m\cdot q(n)]$ and the signal $\Psi[\Omega_m\cdot q(n+1)-\Omega_m\cdot q(n-1)]$ for generating the value $\Omega_q$, where

$$\frac{1}{2}\cdot\sqrt{\frac{\Psi\big[\Omega_m\cdot q(n+1)-\Omega_m\cdot q(n-1)\big]}{\Psi\big[\Omega_m\cdot q(n)\big]}} = \frac{1}{2}\cdot\sqrt{\frac{4\cdot\Omega_m^2\cdot\sin^4\Omega_q}{\Omega_m^2\cdot\sin^2\Omega_q}} = \sin\Omega_q \approx \Omega_q \qquad (23).$$

In the case of an AM signal, it is possible to obtain, from the modulating signal a(n), the value A of the field amplitude of the modulated signal x(n) of AM type, where

$$A = \frac{\max\{a(n)\}+\min\{a(n)\}}{2} \qquad (24)$$

To such end, the processing means 30 are able to receive the signal a(n) in input for generating the maximum value of a(n) max[a(n)] and the minimum value of a(n) min[a(n)] for a predetermined number of samples of the signal a(n).

Also for an AM signal, the carrier signal $f_c$, where

$$f_c \overset{\Delta}{=} \frac{\Omega_c\cdot f_s}{2\cdot\pi} \qquad (25)$$

is an important parameter for verifying the reception channel centring. In this case the processing means 30 are able to process the first filtered signal $\Psi_{F_{AM}}[x(n)]$ and the second filtered signal $\Psi_{F_{AM}}[x(n+1)-x(n-1)]$ for generating the value $\Omega_c$, where

$$\Omega_c = \frac{1}{2} \cdot \arccos\left\{ 1 - \frac{\Psi_{F_{AM}}\big[x(n+1) - x(n-1)\big]}{2 \cdot \Psi_{F_{AM}}\big[x(n)\big]} \right\} = \qquad (26)$$

$$= \frac{1}{2} \cdot \arccos\left\{ 1 - \frac{4 \cdot A^2 \cdot \big[1 + m \cdot \sin(\Omega_a \cdot n)\big]^2 \cdot \sin^4 \Omega_c}{2 \cdot A^2 \cdot \big[1 + m \cdot \sin(\Omega_a \cdot n)\big]^2 \cdot \sin^2 \Omega_c} \right\}$$

from which, applying the expression (25), the value of the carrier frequency $f_c$ is obtained.

Subsequently, it is possible to determine the value $\Omega_a$ of the bandwidth of the AM modulating signal. To this end, the processing means 30 are able to apply the Teager-Kaiser $\Psi$ function to the modulating signal a(n) for generating the signal $\Psi[a(n)]$, where

$$\Psi\big[a(n)\big] = A^2 \cdot \left\{ m^2 \cdot \sin^2 \Omega_a + 4 \cdot m \cdot \sin^2 \frac{\Omega_a}{2} \cdot \cos(\Omega_a \cdot n) \right\} \qquad (27)$$

The processing means 30 are moreover able to receive the signal $\Psi[a(n)]$ in input for generating the maximum value of $\Psi[a(n)]$ max$\{\Psi[a(n)]\}$ and the minimum value of $\Psi[a(n)]$ min$\{\Psi[a(n)]\}$ for a predetermined number of samples of the signal $\Psi[a(n)]$, where:

$$\max\big\{\Psi\big[a(n)\big]\big\} = A^2 \cdot \left[ m^2 \cdot \sin^2 \Omega_a + 4 \cdot m \cdot \sin^2 \frac{\Omega_a}{2} \right] \qquad (28)$$

and

$$\min\big\{\Psi\big[a(n)\big]\big\} = A^2 \cdot \left[ m^2 \cdot \sin^2 \Omega_a - 4 \cdot m \cdot \sin^2 \frac{\Omega_a}{2} \right] \qquad (29).$$

For small values of $\Omega_a$, $\Omega_a \approx \sin \Omega_a$. From the expressions (28) and (29), and having calculated the value of the modulation index m and amplitude A, one has:

$$\sin \Omega_a = \frac{1}{A \cdot m} \cdot \sqrt{\frac{\max\big\{\Psi\big[a(n)\big]\big\} + \min\big\{\Psi\big[a(n)\big]\big\}}{2}}$$

from which one obtains $\Omega_a$.

The receiver 1 also comprises storage means (not shown in the figures) in communication with the processing means 30,31. In particular, the storage means are able to store at least three consecutive values x(n-1), x(n), x(n+1) of the samples of the digital signal x(n) generated by the analog-digital converter means 20,21 to permit the processing means 30,31 to calculate the value of the first signal $\Psi[x(n)] = [x(n)]^2 - x(n+1) \cdot x(n-1)$.

The storage means, or alternatively different means, can be foreseen for storing the values q(n-1), q(n), q(n+1) of the samples of the modulating signal q(n) generates by the processing means 31, so to store the values of the signals $\Psi[x(n)-x(n-1)]$, $\Psi[x(n+1)-x(n)]$, $\Psi[x(n)]$, $\Psi[\Omega_m \cdot q(n)]$, $\Psi[\Omega_m \cdot q(n+1) - \Omega_m \cdot q(n-1)]$ necessary for obtaining the characteristic parameters of the signal x(n) of FM type. As shown in figure 2, the storage means can be in the delay blocks 53,54.

Advantageously, the receiver 1 comprises a digital signal processor device or DSP 40 in which the processing means 30,31 and the storage means are incorporated. In this case, the processing means 30,31 are advantageously achieved through a sequence of logic instructions implemented due to the logic present in the DPS 40.

The receiver 1 moreover comprises automatic control gain means, indicated with 24 and 25, respectively, for the circuitries 11 and 12. The automatic control gain means 24,25 are each coupled with the DSP 40 and with the amplifier means of the respective circuitries 11,12 for controlling the thresholds NAGC and WAGC of the single amplifiers of the amplification stages 10,15.

In accordance with one embodiment of the invention, the automatic control gain means 24,25 each comprise a digital-analog converter which generates an analog signal for controlling the threshold values NAGC and WAGC of the amplifiers.

The receiver 1 moreover comprises a digital-analog converter 26 able to control the band-pass filter 8 and a corresponding digital-analog converter 27 able to control the band-pass filter 14.

In particular, the digital-analog converters 26,27 permit adjusting the tuning frequency $f_c$ of the respective band-pass filters 8,14, varying the voltage level required by the variable capacity diodes or varactors present in the filters 8,14 for fixing the tuning frequency $f_c$.

If the voltage supplied by the digital-analog converters 26,27 is not sufficient to drive the variable capacity diodes of the band-pass filters 8,14, the use is foreseen of respective voltage elevators 28,29 coupled to the output of the digital-analog converters 26,27 and to the diodes themselves for increasing the level of voltage supplied by the converters 26,27.

Advantageously, the filtering means of the analog signal x(t) drawn from the antennas 4,5 are coupled with the DSP 40 for the centring of the tuning frequency of the band-pass filters 8,14. In accordance with a preferred embodiment, the coupling between the band-pass filters 8,14 and the DSP 40 is achieved by means of a respective resistor 33,34.

The direct coupling between the DSP 40 and the band-pass filters 8,14 permits the DSP 40 to send to the band-pass filters 8,14 a signal or tone having a frequency equal to the frequency $f_c$ of the desired carrier for centring the band of the filters 8,14 around the frequency of the desired radio station and thus maximise the signal-noise ratio.

The sending of this signal or tone advantageously occurs when the receiver 1 is in pre-search mode or rather before the instant in which the receiver 1 is activated by a tuner for carrying out the search for the desired radio station.

The DSP 40 is moreover interfaced with an external microcontroller (not shown in the figures) through communication protocols 41,42, in the example of I2C and SPI type, for the transfer of the control data and through a decoder RDS 43 for the exchange of radio system data RDS. The DSP 40 is also interfaced with internal or external audio digital-analog converter means (not shown in the figures) through communication protocols 44 of SAI type.

Furthermore, the DSP 40 can manage high frequency data flows for special applications, for example radio transmissions of IBOC type, using an interface 45 which sends the encrypted data to an external IBOC decoder (not shown in the figure) which decrypts the data and sends it to the DSP 40 through the protocol SAI 44.

The DSP can also comprise a decoder for stereo signals 46 which interfaces with the DSP 40 to receive the MPX signal and supply the stereo signals of the left and right audio channels, the data related to the driving tone and the subcarrier signal, for example at 57KHz, to the decoder RDS 43.

A frequency converter of the samples 47 can also be foreseen which converts the audio frequency of samples processed by the DPS 40 to that permitted by the internal or external digital-analog audio converter.

The receiver 1 can be inserted in a system 100 comprising the antennas 4,5 able to receive the modulated analog signal x(t) and the receiver 1 according to the above-described invention and having two signal inputs 2,3 coupled to the respective antenna 4,5 for receiving the modulated analog signal x(t).

The receiver 1 can also be inserted in a portable multimedia device (not illustrated in the figures) which comprises a central unit and plurality of circuits, said central unit being able to control the operation of said plurality of circuits, and said plurality of circuits comprising at least one interface chosen from the group comprising a video interface, a keyboard interface, a communication interface, a pen input interface, an audio interface or a combination of these.

The portable multimedia device moreover comprises the antennas 4,5 able to receive the modulated analog signal x(t) and the receiver 1 according to the above-described invention and having two signal inputs 2,3 coupled to the respective antenna 4,5 for receiving the modulated analog signal x(t).

For example, the portable multimedia device described above can be a cellular telephone equipped with a digital media player of MP3 player type and/or MP4 player type and/or WMV player Digital.

As can be appreciated from that described above, the receiver according to the invention permits satisfying the needs stated in the introductive part of the present invention and to overcome the inconveniences of the receivers of the prior art.

In particular, due to the use of the receiver according to the invention, the required circuitry for receiving and demodulating the received modulated signal is drastically reduced. In particular, the receiver according to the invention does not require the use of costly devices such as mixers and external filters for the intermediate frequency. The receiver according to the invention permits achieving a simple and at the same time economical structure, fully satisfying the abovementioned needs.

Of course, a man skilled in the art, in order to satisfy contingent and specific needs, can make numerous

**EP 1 909 397 A1**

modifications and variants to the receiver according to the invention described above, all moreover contained in the protective scope of the invention as defined by the following claims.

**Claims**

1. Receiver (1) for receiving an analog radio frequency signal (x(t)), comprising:

   - analog-digital converter means (20,21) able to receive said analog signal (x(t)) in input, for converting said analog signal (x(t)) into a digital signal (x(n)),

   **characterised in that** it comprises:

   - processing means (30,31) able to:

      - receive said digital signal (x(n)) in input and apply a non-linear Teager-Kaiser function ($\Psi$) to said digital signal x(n) for generating a first signal ($\Psi[x(n)]$) representative of the energy content of said digital signal (x(n)),
      - process said digital signal (x(n)) for generating a derivative signal (x'(n)) representative of the derivative of said digital signal (x(n)),
      - apply said non-linear Teager-Kaiser function ($\Psi$) to said derivative signal (x'(n)) for generating a second signal ($\Psi[x'(n)]$) representative of the energy content of the derivative (x'(n)) of said digital signal (x(n)),
      - process said first signal ($\Psi[x(n)]$) and said second signal ($\Psi[x'(n)]$) for generating at least one characteristic information of said digital signal (x(n)).

2. Receiver (1) in accordance with claim 1, wherein said digital signal (x(n)) is a modulated signal composed of a carrier signal oscillating at a carrier frequency ($f_c$) and by a modulating signal (a(n),q(n)).

3. Receiver (1) in accordance with claim 2, said at least one information comprising at least one characteristic parameter of said carrier signal.

4. Receiver (1) in accordance with claim 3, wherein said at least one characteristic parameter of said carrier signal comprises said carrier frequency ($f_c$).

5. Receiver (1) in accordance with any one of the claims from 2 to 4, wherein said at least one characteristic information of said digital signal (x(n)) comprises the waveform of said modulating signal (a(n),q(n)).

6. Receiver (1) in accordance with claim 5, wherein said digital signal (x(n)) is an AM signal, said processing means (30) being able to process said first signal ($\Psi[x(n)]$) and said second signal ($\Psi[x'(n)]$) for generating a signal representative of the waveform of said modulating signal (a(n)) by applying the following formula:

$$a(n) \cong \frac{2 \cdot \Psi\big[x(n)\big]}{\sqrt{\Psi\big[x(n+1)-x(n-1)\big]}},$$

   where

   $\Psi[x(n)]$ corresponds with said first signal, and
   $\Psi[x(n+1)-x(n-1)]$ corresponds with said second signal.

7. Receiver (1) in accordance with claim 6, wherein said digital signal (x(n)) is an FM signal, said processing means (31) being able to process said first signal ($\Psi[x(n)]$) and said second signal ($\Psi[x'(n)]$) for generating a signal (q(n) $\Omega_m$) representative of the waveform of said modulating signal (q(n)) by applying the following formula:

$$q(n)\cdot\Omega_m \cong \frac{1}{2}\cdot\arccos\left(1 - \frac{\Psi\big[x(n+1)-x(n-1)\big]}{2\cdot\Psi\big[x(n)\big]}\right) - \Omega_c$$

where

$\Psi[x(n)]$ corresponds with said first signal,
$\Psi[x(n+1)-x(n-1)]$ corresponds with said second signal,
$\Omega_c$ corresponds with the angular frequency of carrier frequency ($f_c$).

8. Receiver (1) in accordance with any one of the claims from 2 to 7, wherein said at least one characteristic information of said digital signal (x(n)) comprises at least one characteristic parameter of said modulating signal (a(n),q(n)).

9. Receiver (1) in accordance with claim 8, wherein said at least one characteristic parameter of said modulating signal (a(n),q(n)) comprises the bandwidth of the modulating signal ($\Omega_a$, $\Omega_q$).

10. Receiver (1) in accordance with claim 8 or 9, wherein said digital signal (x(n)) is an AM modulated digital signal, said at least one characteristic parameter of said modulating digital signal (a(n)) comprising the AM modulation index (m).

11. Receiver (1) in accordance with claim 8 or 9, wherein said digital signal (x(n)) is an FM modulated digital signal, said at least one characteristic parameter of said modulating signal (q(n)) comprising the frequency deviation ($\Omega_m$).

12. Receiver (1) in accordance with any one of the claims from 2 to 11, wherein said processing means (30,31) are able to:

- apply said non-linear Teager-Kaiser function ($\Psi$) to said modulating signal (q(n)) for generating a third signal ($\Psi[q(n)]$) representative of the energy content of said modulating signal (q(n)),
- process said modulating signal (q(n)) for generating a second derivative signal (q'(n)) representative of the derivative of said modulating signal (q(n)),
- apply said non-linear Teager-Kaiser function ($\Psi$) to said second derivative function (q'(n)) for generating a fourth signal ($\Psi[q'(n)]$) representative of the energy content of the derivative (q'(n)) of said modulating signal (x(n)),
- process said third signal ($\Psi[q(n)]$) and said fourth signal ($\Psi[q'(n)]$) for generating the value of said frequency deviation ($\Omega_m$), applying the following expression

$$\Omega_m = \frac{2\cdot\Psi\big[\Omega_m\cdot q(n)\big]}{\sqrt{\Psi\big[\Omega_m\cdot q(n+1)-\Omega_m\cdot q(n-1)\big]}},$$

where

$\Psi[\Omega_m\cdot q(n)]$ corresponds to said third signal ($\Psi[q(n)]$), and
$\Psi[\Omega_m\cdot q(n+1)-\Omega_m\cdot q(n-1)]$ corresponds to said fourth signal ($\Psi[q'(n)]$).

13. Receiver (1) in accordance with any one of the claims from 1 to 12, comprising filtering means (35,36) coupled to said processing means (30,31) for filtering the signal generated by said processing means (30,31).

14. Receiver (1) in accordance with claim 13, in which said filtering means (35,36) are able to filter said first signal ($\Psi[x(n)]$) and said second signal ($\Psi[x'(n)]$) to respectively generate a first filtered signal ($\Psi_F[x(n)]$) and a second filtered signal ($\Psi_F[x'(n)]$), said processing means (30,31) being able to process said first filtered signal ($\Psi_F[x(n)]$) and said second filtered signal ($\Psi_F[x'(n)]$) for generating said at least one characteristic information of said digital signal (x(n)).

**15.** Receiver (1) in accordance with any one of the claims from 1 to 14, comprising a digital signal processor device (40), said processing means (30,31) being incorporated into said digital signal processor device (40).

**16.** Receiver (1) in accordance with any one of the claims from 1 to 15, comprising filtering (6,8,13,14) and amplification (9,10,15,16) means able to filter and amplify said analog signal (x(t)) for generating a second filtered and amplified analog signal, said analog-digital converter means (20,21) being able to receive said second analog signal for generating the digital signal (x(n)) in input to said processing means (30,31).

**17.** Receiver (1) in accordance with claim 16, wherein said analog signal (x(t)) is an FM signal, said amplifier means comprising a limiter amplifier (16).

**18.** System (100) comprising:

- at least one antenna (4,5) able to receive a modulated analog signal (x(t)),
- a receiver (1) having at least one signal input (2,3) coupled to said at least one antenna (4,5) to receive said modulated analog signal (x(t)), said receiver (1) being in accordance with any one of the claims from 1 to 17.

**19.** Portable multimedia device comprising:

- a central unit and a plurality of circuits, said central unit being able to control the operation of said plurality of circuits, and said plurality of circuits comprising at least one interface chosen from the group comprising a video interface, a keyboard interface, a communication interface, a pen input interface, an audio interface or a combination of these,
- at least one antenna (4,5) able to receive a modulated analog signal (x(t)),
- a receiver (1) having at least signal input (2,3) coupled to said at least one antenna (4,5) for receiving said modulated analog signal (x(t)),
said receiver (1) being in accordance with any one of the claims from 1 to 17.

FIG.1

FIG.2

**European Patent Office**

## EUROPEAN SEARCH REPORT

Application Number

EP 06 42 5684

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARAGOS, P.; KAISER, J.F.; QUATIERI, T.F.;: "On amplitude and frequency demodulation using energy operators" SIGNAL PROCESSING, IEEE TRANSACTIONS ON, vol. 41, 1 April 1993 (1993-04-01), pages 1532-1550, XP002422867 * abstract * * paragraph [IIIB] * * paragraph [0IVB] * ----- | 1-19 | INV. H04B1/06 H04L27/06 H04L27/14 H03D1/02 H03D3/00 |
| X | MARAGOS P ET AL: "ENERGY SEPARATION IN SIGNAL MODULATIONS WITH APPLICATION TO SPEECH ANALYSIS" IEEE TRANSACTIONS ON SIGNAL PROCESSING, IEEE SERVICE CENTER, NEW YORK, NY, US, vol. 41, no. 10, 1 October 1993 (1993-10-01), pages 3024-3051, XP000404067 ISSN: 1053-587X * abstract * * paragraph [000I] * * paragraph [0III] * * paragraph [00IV] * equation (80) equation (139) equation (140) ----- | 1-19 | |
| X | BALASUBRAMANIAM SANTHANAM ET AL: "Multicomponent AM-FM Demodulation via Periodicity-Based Algebraic Separation and Energy-Based Demodulation" IEEE TRANSACTIONS ON COMMUNICATIONS, IEEE SERVICE CENTER, PISCATAWAY, NJ, US, vol. 48, no. 3, March 2000 (2000-03), pages 473-490, XP011010807 ISSN: 0090-6778 * paragraph [0IIB] * ----- -/-- | 1-19 | TECHNICAL FIELDS SEARCHED (IPC) H04B |

The present search report has been drawn up for all claims

| Place of search | Date of completion of the search | Examiner |
|---|---|---|
| Berlin | 2 March 2007 | Douglas, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 06 42 5684

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/034451 A1 (MADHAVAN POOVANPILLI G [US] ET AL) 19 February 2004 (2004-02-19) * abstract * * paragraph [0001] - paragraph [0002] * * paragraph [0006] - paragraph [0008] * * figure 1A * * paragraph [0019] * * paragraph [0030] - paragraph [0031] * ----- | 1-19 | |
| A | LIPSEY M J ET AL: "On the Teager-Kaiser energy operator low frequency error" THE 2002 45TH. MIDWEST SYMPOSIUM ON CIRCUITS AND SYSTEMS. CONFERENCE PROCEEDINGS. TULSA, OK, AUG. 4 - 7, 2002, MIDWEST SYMPOSIUM ON CIRCUITS AND SYSTEMS, NEW YORK, NY : IEEE, US, vol. VOL. 1 OF 3, 4 August 2002 (2002-08-04), pages 53-56, XP010635495 ISBN: 0-7803-7523-8 * paragraph [0002] * ----- | 1-19 | |

TECHNICAL FIELDS SEARCHED (IPC)

The present search report has been drawn up for all claims

| Place of search | Date of completion of the search | Examiner |
|---|---|---|
| Berlin | 2 March 2007 | Douglas, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 06 42 5684

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2007

| Patent document cited in search report | Publication date | Patent family member(s) | Publication date |
|---|---|---|---|
| US 2004034451 A1 | 19-02-2004 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JAMES F. KAISER.** On a Simple Algorithm to Calculate the Energy of a Signal. *PROC. ICASSP,* 1990, vol. S7.3, 381-384